# DEMANDE DE BREVET EUROPEEN

(11) **EP 3 125 293 A2**
(43) Date de publication de la demande: **01.02.2017**
(21) Numéro de dépôt: 16181598.0
(22) Date de dépôt: 28.07.2016
(51) Int. Cl.: H01L 27/108, H01L 49/02

(54) **ELECTRODE POUR STRUCTURE MÉTAL-ISOLANT-MÉTAL, CAPACITÉ DE TYPE MÉTAL- ISOLANT-MÉTAL, ET PROCÉDÉ DE RÉALISATION D'UNE TELLE ÉLECTRODE ET D'UNE TELLE CAPACITÉ**

(30) Priorité: 28.07.2015 FR 1557206
(71) Demandeur: Commissariat à l'Energie Atomique et aux Energies Alternatives, 75015 Paris (FR); STMicroelectronics (Crolles 2) SAS, 38920 Crolles (FR)
(72) Inventeur: Rodriguez, Guillaume, 38190 Le Champs Prés Froges (FR); Halimaoui, Aomar, 38660 La Terrasse (FR); ORTIZ, Laurent, 38800 Le Pont de Claix (FR)
(74) Mandataire: Talbot, Alexandre

(57) **Abrégé**

L'électrode (3) pour structure de type Métal-Isolant-Métal est formée d'un empilement comprenant successivement une couche en or (7), une couche barrière (8) en oxyde électriquement conducteur et une couche en platine (6). L'oxyde électriquement conducteur (8) est, avantageusement, un oxyde de métal noble, et, préférentiellement, l'oxyde de ruthénium.

L'électrode est disposée sur un substrat (4). La couche en or (7) de l'électrode (3) est séparée du substrat (4) par une couche d'accroche (9) à base de dioxyde de titane.

L'électrode (3) est utilisée pour réaliser une capacité de type Métal-Isolant-Métal.

## Description

### Domaine technique de l'invention

Le domaine de l'invention est celui des multicouches métalliques utilisables en microélectronique pour la réalisation d'interconnexions et, plus particulièrement, pour la réalisation d'électrodes pour structure de type Métal-Isolant-Métal, nécessitant des recuits thermiques à haute température sans dégradation de la conductivité de l'électrode.

### État de la technique

Une structure de type Métal-Isolant-Métal (MIM) peut être utilisée soit pour la réalisation de mémoires, comme une mémoire vive dynamique (ou DRAM pour « Dynamic Random Access Memory ») ou un mémoire non volatile (ou NVM pour « non volatile memory »), soit pour la réalisation de systèmes microélectromécaniques (ou MEMS pour « Microelectromechanical systems »), ou encore pour la réalisation de capacités variables utilisables dans des circuits RF, par exemple.

Les structures MIM comportent une couche de matériau isolant.

Pour les mémoires, si le matériau isolant est un matériau diélectrique, le fonctionnement est basé sur un stockage de charges électrique et, si le matériau isolant est un matériau ferroélectrique, le fonctionnement exploite la variation de la polarisation en fonction du champ électrique.

Dans le cas des MEMS, on utilise un matériau piézoélectrique.

Pour la réalisation de capacités variables, on utilise un isolant (ferroélectrique ou non) dont la capacité varie, de façon importante, avec le champ électrique appliqué aux bornes de la capacité MIM.

Les matériaux de type pérovskite sont tout à fait adaptés, comme matériau isolant, à ce type de structures. En effet, ces matériaux présentent des propriétés physiques remarquables (ferroélectricité, piézoélectricité, pyroélectricité, etc) avec des valeurs de constante diélectrique élevées.

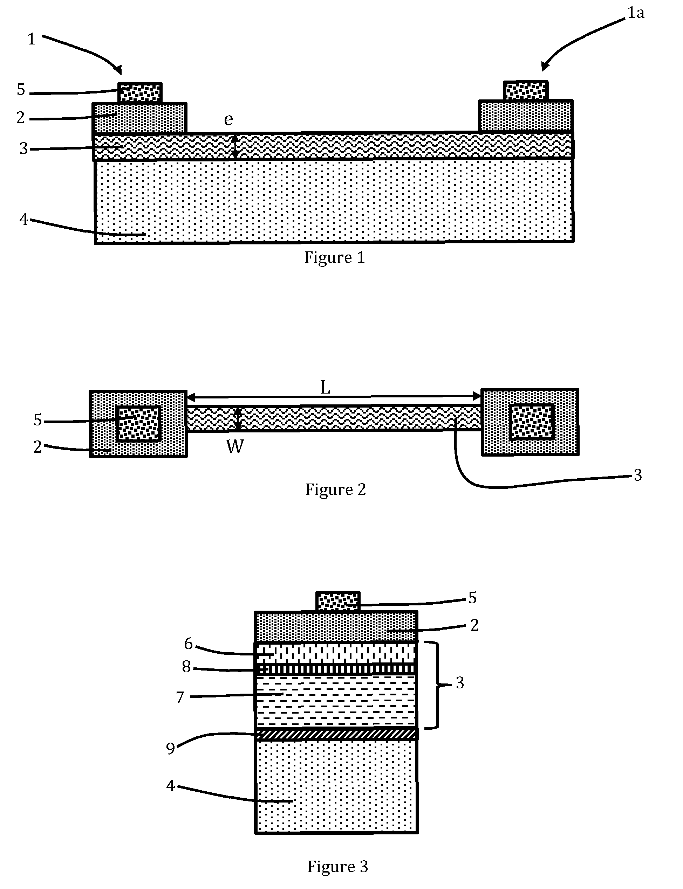

Comme représenté sur la figure 1, les capacités 1 de type MIM sont des condensateurs plans, classiquement formées par une couche en matériau de type pérovskite 2 disposée entre une électrode dite inférieure 3, en contact avec un substrat 4, et une électrode dite supérieure 5.

Afin d'obtenir les meilleures propriétés du matériau de type pérovskite, celui-ci doit être bien cristallisé. Un recuit de cristallisation à haute température (à une température supérieure à 600°C) et sous atmosphère oxydante est donc généralement réalisé après la formation du matériau de type pérovskite sur l'électrode inférieure.

Les propriétés physiques de l'électrode inférieure ne doivent pas être détériorées lors du recuit. L'électrode inférieure est donc classiquement en platine.

Comme représenté sur la figure 1, plusieurs capacités MIM 1, 1a sont généralement déposées sur un même substrat 4, par exemple en silicium oxydé, et sont reliées entre elles par une électrode inférieure 3 commune. Elles peuvent également être reliées à d'autres composants par l'intermédiaire de cette électrode inférieure qui joue le rôle de contact.

Cependant, pour les technologies futures, l'électrode inférieure en platine représente une résistance de ligne parasite qui peut être préjudiciable aux performances du produit final. Il est donc essentiel de réduire la résistance de ligne significativement, pour faciliter son introduction dans un plus grand nombre d'applications.

### Objet de l'invention

L'invention a pour but de remédier au moins en partie aux inconvénients de l'art antérieur et, en particulier, de proposer une électrode présentant une faible résistivité.

Cet objet est atteint par une électrode selon les revendications annexées.

Cet objet est également atteint par une capacité selon les revendications annexées.

Cet objet est également atteint par un procédé de réalisation d'une telle électrode selon les revendications annexées.

Cet objet est également atteint par un procédé de réalisation d'une capacité selon les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en coupe, deux capacités MIM reliées par leur électrode inférieure, selon l'art antérieur,
- la figure 2 représente en vue de dessus, de manière schématique, deux capacités MIM reliées par leur électrode inférieure,
- la figure 3 représente, de manière schématique, en coupe, une capacité MIM selon un mode de réalisation de l'invention,
- la figure 4 représente la surface d'une électrode Au/WN/Pt, après recuit, observée au microscope optique,
- la figure 5 représente la surface d'une électrode Au/RuO₂/Pt, après recuit, observée au microscope optique,
- la figure 6 représente la profondeur de diffusion de l'or dans le platine en fonction de la température,
- la figure 7 représente un profil Auger d'un empilement Ti/Au/RuO₂/Pt, après recuit,
- la figure 8 représente un profil Auger d'un empilement TiO₂/Au/RuO₂/Pt, après recuit.

### Description d'un mode de réalisation préférentiel de l'invention

La résistance de ligne d'une électrode est définie par la relation R = pL/We Avec, p la résistivité du métal,
et, comme représenté sur les figures 1 et 2 :
L est la longueur de la ligne
W est la largeur de la ligne
e est l'épaisseur de la ligne.

Les paramètres L et W des motifs des lignes du dispositif sont fixés pour une technologie donnée par des règles de dessins.

De manière classique, la ligne électriquement conductrice qui relie un condensateur à un autre élément est réalisée par l'électrode inférieure du condensateur, c'est-à-dire par une ligne de platine.

Pour réduire la résistance de ligne, différentes options se présentent. Il est possible de réaliser une ligne conductrice à partir d'un métal ayant une résistivité inférieure à celle du platine et/ou d'augmenter l'épaisseur e de la ligne et donc de l'électrode.

Pour faciliter l'intégration de cette technologie de condensateur dans des applications plus variées, il est préférable de réduire la résistance de ligne d'un facteur 50.

Une manière simple de corriger ce problème est de déposer un film qui est beaucoup plus épais, environ 50 fois plus épais. L'épaisseur conventionnelle déposée de platine étant de 0,1µm, pour atteindre les performances demandées, il sera nécessaire de déposer un film de platine ayant une épaisseur sensiblement égale à 5µm. Une épaisseur aussi importante de platine n'est pas envisageable pour une utilisation industrielle. En effet, elle va engendrer des problèmes mécaniques (déformation du substrat, risque de décollement du platine...) ainsi que des problèmes de coût et d'intégration.
Il apparaît donc judicieux de remplacer le matériau formant l'électrode inférieure. Le platine présente une résistivité de 11 *µ*Ω.cm. Parmi les métaux présentant une résistivité inférieure à celle du platine, les meilleurs candidats sont le cuivre (résistivité de 1,75*µ*Ω.cm) et l'or (résistivité de 2,25*µ*Ω.cm).

Il n'est pas possible de déposer un matériau diélectrique de type pérovskite ayant les performances électriques recherchées sur du cuivre et/ou de l'or. Il est donc particulièrement avantageux d'associer le platine à l'un de ces deux métaux pour obtenir une diminution de la résistivité globale de la ligne, par rapport à une ligne uniquement en platine, et de bonnes performances du matériau diélectrique de type pérovskite.

Comme représentée sur la figure 3, l'électrode inférieure 3 est formée d'un empilement comprenant une couche en or 7 et une couche en platine 6.

La couche de platine a une épaisseur comprise entre 80nm et 120nm. Avantageusement, la couche de platine 6 a une épaisseur d'environ 100nm et l'épaisseur de la couche d'or 7 sera adaptée par l'homme du métier pour obtenir la résistivité de ligne désirée. La couche d'or présente, avantageusement, une épaisseur comprise entre 500nm et 2µm.

Une telle épaisseur de platine conduit à une bonne cristallisation du matériau diélectrique de type pérovskite lors du recuit et, en même temps, cette épaisseur reste suffisamment faible (très inférieure à 5*µ*m) pour éviter les contraintes mécaniques (décollement de la couche, etc) et pour ne pas augmenter les coûts de production.

Par exemple, pour réduire la résistivité d'un facteur 50 d'une électrode, ayant une couche en platine 6 présentant une épaisseur d'environ 100nm, une couche en or 7 d'une épaisseur d'environ 1*µ*m est ajoutée.
Pour réduire la résistivité de la même électrode d'un facteur 100, la couche en or 7 présentera une épaisseur de 2*µ*m.
L'épaisseur de la couche en or 7 est, avantageusement, inférieure à 5*µ*m pour éviter les décollements, et de préférence, la couche en or 7 a une épaisseur allant de 1*µ*m à 2*µ*m.

Le tableau suivant donne les résistances R de différentes électrodes avant et après recuit à 700°C sous dioxygène pour recristalliser le matériau diélectrique de type pérovskite.

| Empilement | R avant recuit (Ω) | R après recuit (Ω) |
|---|---|---|
| Pt(100nm) | 1,5 | 1,42 |
| Cu(1*µ*m)/Pt(100nm) | 0,019 | isolant |
| Au(1*µ*m)/Pt(100nm) | 0,028 | 0,144 |

Avant recuit, les résistances de ligne des électrodes Pt/métal sont inférieures d'au moins un facteur 50 à celles de la résistance de ligne d'une électrode en platine.

Les inventeurs ont observé que, lors du recuit en présence de dioxygène, le cuivre s'oxyde et devient isolant, et l'or diffuse dans le platine, formant un alliage or-platine.

Les résistivités de ligne, après recuit, augmentent. Pour une ligne en or et en platine, le gain en résistivité n'est plus que d'un facteur 10 par rapport à la résistivité d'une ligne de platine.

En effet, lorsqu'un empilement formé d'au moins deux couches métalliques est soumis à un traitement thermique, il se produit une inter-diffusion des deux couches métalliques conduisant à une augmentation importante de la résistivité (C. H. Johansson and J. O. Linde, « Rontgenographische und elektrische Untersuchungen des CuAu-Systems"; Annalen der Physik, 1936, 25, 1-48). Cette augmentation de la résistivité conduit à une augmentation de la résistance parasite lorsque cet empilement multicouche est utilisé pour la réalisation d'une interconnexion ou, plus particulièrement, pour la réalisation d'une électrode d'un dispositif MIM.

La demanderesse a découvert que la présence d'une couche barrière en oxyde électriquement conducteur 8, non seulement, empêchait l'interdiffusion du platine et de l'or, mais permettait, également, d'obtenir une résistance de ligne plus faible après recuit. Par couche barrière, on entend une couche mince pouvant empêcher l'interdiffusion de deux métaux, en particulier, ici il s'agit de la diffusion de l'or dans le platine.

L'oxyde est, avantageusement, un oxyde de métal noble. Il est choisi parmi l'oxyde de ruthénium ou tout oxyde d'un métal noble tel que l'oxyde de platine, ou préférentiellement, l'oxyde d'iridium.
Une couche en oxyde de ruthénium est, avantageusement, facile à réaliser et résiste à un traitement à haute température sous atmosphère oxydante.

L'électrode, selon l'invention, pour une structure de type Métal-Isolant-Métal, est formée d'un empilement comprenant successivement une couche en or 7, une couche barrière en oxyde de ruthénium 8 et une couche en platine 6 (figure 3).

La résistance de ligne d'une telle électrode 3 a été mesurée avant et après recuit. A titre comparatif, la résistance de ligne d'une électrode comportant une couche barrière en WN a également été mesurée. Ce matériau est couramment utilisé en microélectronique.

Le tableau suivant donne les résistances R des différentes électrodes avant et après recuit à 700°C sous dioxygène.

| Empilement | R avant recuit (Ω) | R après recuit (Ω) |
|---|---|---|
| Pt(100nm) | 1,5 | 1,42 |
| Au(1*µ*m)/Pt(100nm) | 0,028 | 0,144 |
| Au(1*µ*m)/WN(10nm)/Pt(100nm) | 0,036 | 0,068 |
| Au(1*µ*m)/RuO₂(60nm)/Pt(100nm) | 0,031 | 0,0241 |

Avec une couche intercalaire en WN, la résistance de l'électrode augmente après recuit.

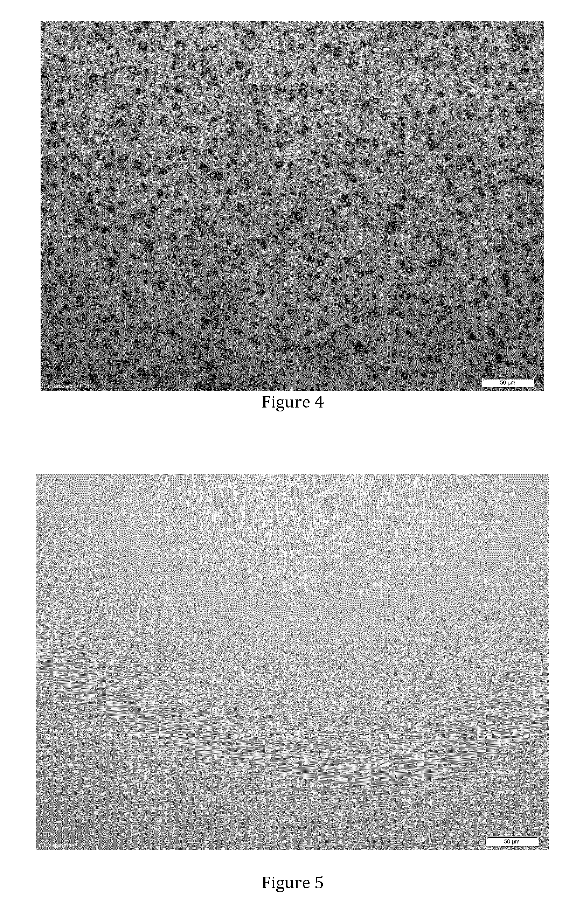

De plus, après recuit, comme illustré à la figure 4, la couche de platine de l'électrode présente des défauts (trous, bosses). Ces défauts semblent provenir de l'oxydation de WN, lors du recuit, qui conduit à la formation de WO₃ et N₂ et à un dégagement gazeux à travers la couche de platine.

L'empilement Au/RuO₂/Pt est thermiquement et chimiquement stable. Même avec le recuit thermique, il n'y a pas de délamination ni de diffusion entre l'or et le platine. Comme illustré sur la figure 5, les couches obtenues sont de très bonne qualité. Il n'y a pas de défauts en surface.

L'oxyde de ruthénium forme une excellente barrière de diffusion. Une couche barrière en oxyde de ruthénium peut être utilisée comme couche barrière même à haute température (au moins 700°C) et sous atmosphère oxydante.

La résistance de ligne de l'électrode Au/RuO₂/Pt, après recuit, est 50 fois inférieure à celle d'une électrode en platine.

La résistance de ligne d'une telle électrode diminue après recuit. Cette diminution peut être due à une meilleure qualité des couches, et à leur recristallisation durant le traitement thermique.

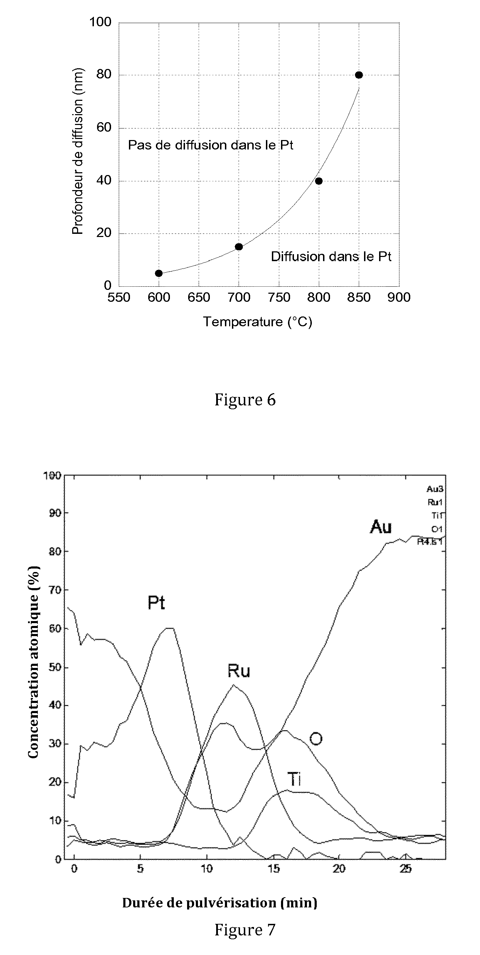

La couche mince en oxyde de ruthénium 8 a une épaisseur supérieure ou égale à 15nm. Comme représenté sur la figure 6, une couche en oxyde de ruthénium 8 avec une telle épaisseur forme une barrière de diffusion suffisante pour des recuits à 700°C. L'or ne diffuse pas dans le platine.
Préférentiellement, la couche mince en oxyde de ruthénium 8 a une épaisseur supérieure ou égale à 40nm, et, encore plus préférentiellement, supérieure ou égale à 80nm.
Ces épaisseurs autorisent des recuits de recristallisation jusqu'à 800°C.
Plus l'épaisseur de la couche barrière est épaisse, plus la couche barrière est efficace à plus haute température.
Par exemple, pour une épaisseur de 80nm, il est possible de faire des recuits jusqu'à 850°C de 60 secondes sans que l'or ne diffuse dans le platine.
La durée des recuits est comprise entre 15 secondes et 10 minutes, et de préférence entre 30 secondes et 5 minutes.

L'électrode 3 est disposée sur un substrat 4 (figure 3). La couche en or 7 de l'électrode 3 est séparée du substrat 4 par une couche d'accroche 9 à base de dioxyde de titane. Cette couche d'accroche 9 favorise l'adhérence de la couche d'or 7 sur le substrat.

Par la couche d'accroche est à base de dioxyde de titane, on entend que la couche d'accroche est en dioxyde de titane ou que la couche d'accroche est un bicouche TiO₂/Métal, le TiO₂ étant en contact avec la première électrode. Le métal est choisi parmi les métaux ayant une bonne adhérence sur l'oxyde de silicium, notamment. Le métal peut être choisi parmi le titane, le chrome, ou encore le tantale. Il s'agit, préférentiellement, d'un bicouche TiO₂/Ti.

La couche d'accroche entre une couche en or et un substrat est généralement en titane. Cependant, la demanderesse a constaté, de manière inattendue, qu'une couche d'accroche 9 en titane conduisait à la diffusion de l'or jusqu'à la couche de platine malgré la présence de la couche barrière 8 en RuO₂.

La courbe de la figure 7 représente un profil Auger à travers l'électrode, depuis la couche de platine 6 jusqu'à la couche d'accroche en titane 9, après recuit.
Le titane diffuse jusqu'à la couche barrière 8 en RuO₂, avec laquelle il réagit pour former du ruthénium et du dioxyde de titane, ce qui dégrade les propriétés de la couche barrière 8 et conduit à la diffusion de l'or dans le platine.

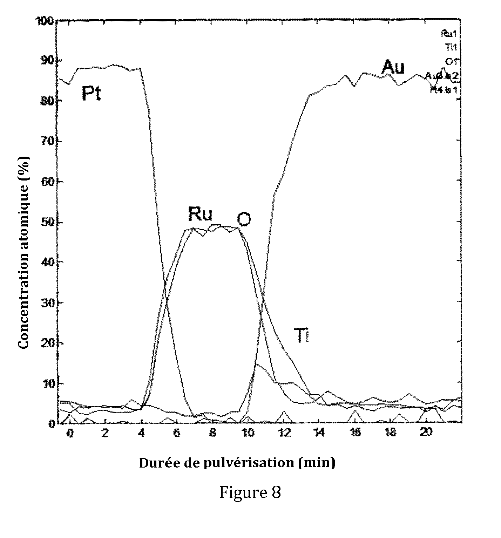

En revanche, lorsque la couche d'accroche 9 comporte une couche en dioxyde de titane en contact avec la première électrode 3, même après recuit, la couche barrière 8 en dioxyde de ruthénium est intègre (figure 8). L'or ne diffuse pas dans la couche de platine 6. La résistance de ligne de l'électrode 3 est faible.

La première électrode 3 est disposée sur un substrat 4.
Selon un mode de réalisation, le substrat est intrinsèquement électriquement isolant. Le substrat est, par exemple, en verre.
Pour des températures de recuit plus faible, le substrat pourrait également être en polymère.
Dans un autre mode de réalisation, le substrat 4 est électriquement conducteur ou semi-conducteur. La surface du substrat 4 est, avantageusement, recouverte par une couche en matériau électriquement isolant, dite couche d'isolation, afin d'isoler la structure MIM 1 dudit substrat 4.
Le matériau électriquement isolant est, avantageusement, en oxyde électriquement isolant, comme, par exemple, en oxyde de silicium. Selon une autre alternative, il peut s'agir d'un nitrure de silicium ou encore d'un oxyde de tantale.
La couche d'isolation a une épaisseur de quelques nanomètres, voire de quelques dizaines de nanomètres.
Le substrat est, par exemple, en silicium ou en germanium, et est recouvert par une couche d'oxyde électriquement isolant. Le substrat 4 est, avantageusement, en silicium oxydé.
Une couche d'accroche 9 à base de dioxyde de titane est, avantageusement, disposée entre la première électrode 3 et le substrat 4, ou entre la première électrode 3 et la couche électriquement isolante si le substrat 4 est électriquement conducteur.

Le procédé de réalisation d'une électrode 3 telle que précédemment décrite comprend les étapes successives suivantes :
a) fournir un substrat 4 recouvert par une couche d'accroche 9 à base de dioxyde de titane,
b) former une électrode 3 sur la couche d'accroche 9, l'électrode 3 étant formée par dépôts successifs d'une couche en or 7, d'une couche barrière 8 en oxyde de ruthénium et d'une couche en platine 6.

L'électrode 3 peut être utilisée pour former la première électrode d'une structure MIM.
Préférentiellement, l'électrode 3 est utilisée pour réaliser une capacité 1, de type Métal-Isolant-Métal, comprenant (figure 3) :
- une première électrode 3, telle que précédemment décrite,
- une seconde électrode 5,
- une couche en matériau diélectrique de type pérovskite 2, disposée entre la première électrode 3 et la seconde électrode 5.

Le matériau diélectrique de la capacité présente une constante diélectrique élevée. Par élevée, on entend d'au moins 500. Le matériau diélectrique de type pérovskite est électriquement isolant.
Le matériau diélectrique de type pérovskite est un oxyde, avantageusement, choisi parmi Pb[ZrₓTi₁₋ₓ]O₃ (PZT), SrTiO₃ (STO), BaTiO₃ (BTO), Ba[SrₓTi₁₋ₓ]O₃ (BST).

Le procédé de réalisation d'une capacité 1 de type MIM comprend, après la réalisation des étapes a) et b) précédemment décrites, les étapes successives suivantes :
c) former une couche en matériau diélectrique de type pérovskite 2 sur la première électrode 3,
d) réaliser un traitement thermique à une température d'au moins 600°C sous oxygène de manière à cristalliser le matériau diélectrique,
e) former une seconde électrode 5 sur la couche en matériau diélectrique cristallisé 2.

La température du traitement thermique est avantageusement supérieure ou égale à 700°C.
Préférentiellement, la température du traitement thermique est supérieure ou égale à 850°C afin de bien cristalliser la couche de matériau diélectrique de type pérovskite 2.

Le procédé va être décrit à l'aide de l'exemple suivant donné à titre illustratif et non limitatif.

Le substrat fourni à l'étape a) est réalisé selon les étapes suivantes :
- fournir un substrat massif en silicium,
- oxyder le substrat massif de manière à former une couche d'oxyde d'environ 100nm à sa surface,
- déposer une couche mince en dioxyde de titane sur l'oxyde de silicium, par pulvérisation, la couche mince ayant une épaisseur de quelques nanomètres, par exemple 5nm.

Selon une autre alternative, le dioxyde de titane peut être obtenu par oxydation d'une couche de titane déposée sur l'oxyde de silicium. De manière inattendue, les inventeurs ont observé que le dépôt d'une couche de titane qui est oxydée par la suite fournit de meilleurs résultats que le dépôt d'une couche de dioxyde de titane. Cela permet notamment une meilleure adhérence des métaux nobles tels que l'or sur une couche en oxyde de silicium.

A titre d'exemple, de bons résultats ont été obtenus avec le dépôt d'une couche de titane ayant une épaisseur de 10nm suivi par une étape d'oxydation à la température de 750°C sous une atmosphère comportant ou constituée d'oxygène. Les conditions opératoires sont avantageusement définies pour réaliser l'oxydation complète de la couche de titane en dioxyde de titane, la durée de l'étape d'oxydation est par exemple égale à 5 minutes. L'épaisseur de la couche de titane peut être comprise entre 5nm et 50nm ou entre 5nm et 20nm.

En variante, le dépôt de la couche de titane peut être réalisé à une température supérieure à 200°C, par exemple entre 200°C et 400°C. Il est également possible de prévoir que l'oxydation de la couche de titane peut être réalisée à une température supérieure à 500°C. La durée de l'étape de recuit est ajustée pour réaliser l'oxydation complète de la couche de titane.

L'électrode inférieure formée lors de l'étape b) est réalisée par dépôts successifs d'or, d'oxyde de ruthénium, et de platine par pulvérisation. L'électrode est ensuite gravée de manière à avoir le motif désiré.

Le matériau diélectrique PZT est déposé par voie sol-gel (étape c)), par dépôt à la tournette (ou « spin-coating »). Le dépôt est ensuite séché pendant quelques minutes à une centaine de degrés. Une couche de PZT d'environ 200nm est obtenue.

Le recuit de cristallisation (étape d)) est réalisé à 700°C sous O₂ pendant 60 secondes.

Lors de l'étape e), une électrode supérieure en platine est déposée par pulvérisation. L'électrode supérieure présente une épaisseur d'environ 100nm.

Les électrodes présentent une faible résistance de ligne. La résistance de ligne est inférieure d'un facteur 50 par rapport aux électrodes classiques en platine. Les capacités contenant de telles électrodes sont particulièrement intéressantes pour des applications à haute fréquence.

## Revendications

1. Electrode (3) pour structure de type Métal-Isolant-Métal formée d'un empilement comprenant successivement, en direction de l'isolant de la structure de type Métal-Isolant-Métal, une couche en or (7), une couche barrière en oxyde électriquement conducteur (8) et une couche en platine (6), l'oxyde électriquement conducteur étant, avantageusement, un oxyde de métal noble, et, préférentiellement, l'oxyde de ruthénium.

2. Electrode (3) selon la revendication 1, **caractérisée en ce qu'**elle est disposée sur un substrat (4) et **en ce que** la couche en or (7) de l'électrode (3) est séparée du substrat (4) par une couche d'accroche (9) à base de dioxyde de titane.

3. Electrode (3) selon la revendication 2, **caractérisée en ce que** la couche d'accroche (9) est en dioxyde de titane.

4. Electrode (3) selon la revendication 2, **caractérisée en ce que** la couche d'accroche (9) est un bicouche TiO₂/métal, le métal étant choisi parmi le titane, le chrome, ou le tantale.

5. Electrode (3) selon l'une des revendications 2 et 3, **caractérisée en ce que** la couche d'accroche (9) sépare complètement la couche en or (7) et le substrat (4).

6. Electrode (3) selon l'une quelconque des revendications 1 à 5, **caractérisée en ce que** la couche en platine (6) a une épaisseur d'environ 100nm et la couche en or (7) a une épaisseur allant de 1*µ*m à 2*µ*m.

7. Electrode (3) selon l'une quelconque des revendications précédentes, **caractérisée en ce que** la couche barrière (8) est en oxyde de ruthénium et **en ce qu'**elle a une épaisseur supérieure ou égale à 15nm, de préférence supérieure ou égale à 40nm, et encore de préférence, supérieure ou égale à 80nm.

8. Capacité (1) de type Métal-Isolant-Métal comprenant :
- une première électrode (3) selon l'une quelconque des revendications 1 à 7,
- une seconde électrode (5),
- une couche en matériau diélectrique (2) de type pérovskite, disposée entre la première électrode (3) et la seconde électrode (5).

9. Procédé de réalisation d'une électrode (3) selon l'une quelconque des revendications 1 à 7 comprenant les étapes successives suivantes :
- fournir un substrat (4) recouvert par une couche d'accroche (9) à base de dioxyde de titane,
- former une électrode (3) sur la couche d'accroche (9), l'électrode (3) étant formée par dépôts successifs d'une couche en or (7), d'une couche barrière en oxyde électriquement conducteur (8) et d'une couche en platine (6), l'oxyde électriquement conducteur étant, avantageusement, un oxyde de métal noble, et, préférentiellement, l'oxyde de ruthénium.

10. Procédé selon la revendication 9, **caractérisé en ce que** la couche en platine (6) a une épaisseur d'environ 100nm et la couche en or (7) a une épaisseur allant de 1*µ*m à 2*µ*m.

11. Procédé selon l'une des revendications 9 et 10, **caractérisé en ce que** la couche barrière (8) est en oxyde de ruthénium et **en ce qu'**elle a une épaisseur supérieure ou égale à 15nm, de préférence supérieure ou égale à 40nm, et encore de préférence, supérieure ou égale à 80nm.

12. Procédé selon l'une quelconque des revendications 9 à 11, **caractérisée en ce que** la couche d'accroche (9) est en dioxyde de titane ou un bicouche TiO₂/métal, le métal étant choisi parmi le titane, le chrome, ou le tantale.

13. Procédé selon la revendication précédente, **caractérisée en ce qu'**il comporte le dépôt d'une couche de titane puis une étape d'oxydation de la couche de titane pour former la couche d'accroche (9) en dioxyde de titane.

14. Procédé de réalisation d'une capacité (1) selon la revendication 8 comprenant les étapes successives suivantes :
- réaliser une première électrode (3) selon le procédé des revendications 9 à 13,
- former une couche en matériau diélectrique (2) de type pérovskite sur la première électrode (3),
- réaliser un traitement thermique à une température d'au moins 600°C sous oxygène de manière à cristalliser le matériau diélectrique (2),
- former une deuxième électrode (5) sur la couche en matériau diélectrique (2) cristallisé.

15. Procédé selon la revendication précédente, **caractérisé en ce que** la température du traitement thermique est supérieure ou égale à 700°C, de préférence supérieure ou égale à 850°C.
